# DEMANDE DE BREVET EUROPEEN

(11) **EP 2 031 654 A2**
(43) Date de publication de la demande: **04.03.2009**
(21) Numéro de dépôt: 08156210.0
(22) Date de dépôt: 14.05.2008
(51) Int. Cl.: H01L 21/762

(54) **Procédé de fabrication d'une structure pour épitaxie sans zone d'exclusion**

(30) Priorité: 06.06.2007 FR 0755512
(71) Demandeur: S.O.I.Tec Silicon on Insulator Technologies, 38190 Bernin (FR)
(72) Inventeur: Letertre, Fabrice, 38240, Meylan (FR); Arena, Chantal, Mesa, AZ (US)
(74) Mandataire: Desormiere, Pierre-Louis

(57) **Abrégé**

L'invention concerne un procédé de fabrication d'une structure composite (13) pour épitaxie comprenant au moins une couche de germe cristallin de croissance (11) de matériau semi-conducteur sur un substrat support (10), le substrat support (10) et la couche de germe cristallin de croissance (11) présentant à la périphérie de leur face de collage un chanfrein ou une zone de tombée de bord. Le procédé comprend au moins une étape de collage par adhésion moléculaire (S4) de la couche de germe cristallin de croissance (11) sur le substrat support (10) et au moins une étape d'amincissement (S6) de la couche de germe cristallin de croissance (11), ladite couche de germe cristallin de croissance présentant un diamètre après amincissement identique à son diamètre initial.

## Description

### Domaine technique et art antérieur

La présente invention concerne le domaine des couches de matériaux semi-conducteurs tels que ceux de type III/N, III/V ou de la colonne IV, réalisées par croissance épitaxiale (homoépitaxie ou hétéroépitaxie) à partir de structures composites comprenant typiquement un substrat support et une couche de germe cristallin de croissance à partir de laquelle la croissance épitaxiale de la couche de matériau semi-conducteur est réalisée. Par l'expression "matériaux de type III/V" il faut comprendre qu'il s'agit de matériaux constitués d'éléments issus de la colonne III et de la colonne V de la classification périodique des éléments, ces matériaux peuvent être binaires, ternaires ou quaternaires.

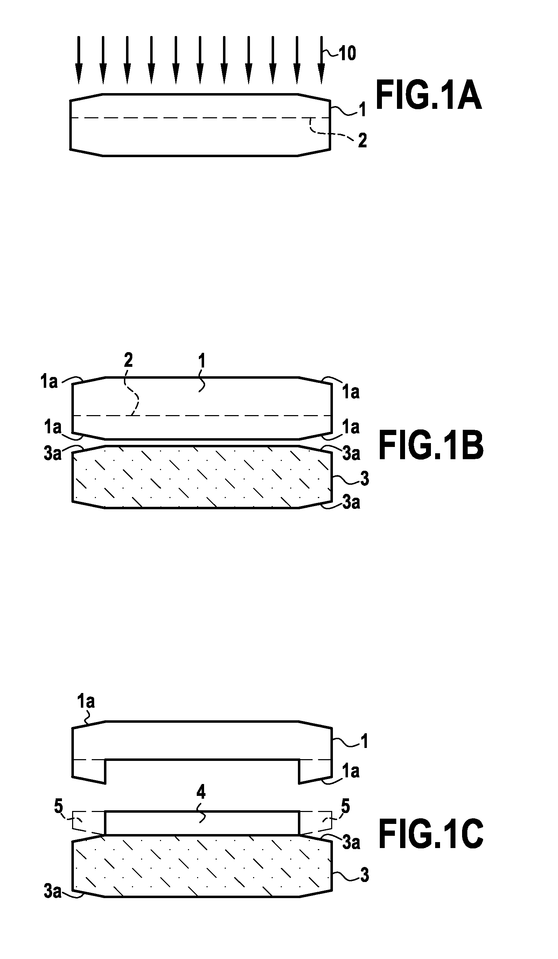

Ce type de structure composite est généralement réalisée selon la technologie Smart-Cut® bien connue. Un exemple de réalisation d'une structure composite pour croissance épitaxiale selon la technologie Smart-Cut® est décrit dans les figures 1A à 1C.

La figure 1A représente un substrat source ou substrat donneur 1 dont une face est soumise à l'implantation par bombardement d'espèces ioniques 10 (par exemple des ions H+) de manière à créer à une certaine profondeur dans le substrat une zone de fragilisation 2. Comme illustré sur la figure 1B, on met en contact intime la face du substrat donneur 1 qui a subi l'implantation avec un substrat support ou "receveur" 3 (collage par adhésion moléculaire). On réalise ensuite, comme représenté sur la figure 1C, un clivage du substrat donneur au niveau de la zone de fragilisation pour transférer la partie située entre la face soumise à l'implantation et la zone de fragilisation du substrat donneur sur le substrat receveur, la partie transférée constituant une couche de germe cristallin de croissance 4.

Comme illustré sur la figure 1C, lors de la fabrication de substrats composites par transfert d'une couche mince de germe cristallin de croissance sur un substrat support par la technologie Smart-Cut®, une "zone d'exclusion" ou couronne 5, qui correspond à une partie de la couche mince 4 non transférée, se forme à la périphérie du substrat support 1.

En effet, tels qu'illustrés très schématiquement sur la figure 1B et selon les normes SEMI^{™}, le substrat donneur 1 et le substrat support 3 comportent respectivement en périphérie de leurs surfaces un chanfrein ou une "tombée de bord" 1a et 3a (également connu sous les termes anglais de "edge rounding") dont le rôle est de faciliter leur manipulation et d'éviter les bris de bords qui pourraient se produire si ces bords étaient saillants, de tels bris étant sources de contamination en particules des surfaces des plaques.

Cependant, la présence d'un tel chanfrein empêche un bon contact entre le substrat support et le substrat donneur au niveau de leur périphérie. La force de collage obtenue en périphérie de l'assemblage est, par conséquent, insuffisante pour retenir sur tout son diamètre la partie du substrat donneur à transférer sur le substrat support. La couche de germe cristallin de croissance 4 à transférer présente une faible épaisseur qui est limitée à plusieurs centaines de nanomètres en raison de sa formation par implantation. Cette faible épaisseur fragilise mécaniquement la couche de germe qui se rompt au niveau du chanfrein lors du détachement. La couche 4 détachée du substrat donneur 1 ne se transfère donc pas à la périphérie du support, ce qui crée la zone d'exclusion 5.

Une couche épaisse formée par épitaxie sur une couche de germe cristallin de croissance comportant une zone d'exclusion se conformera au diamètre tronqué de la couche mince de germe transférée qui est plus petit que celui du substrat support normalisé, ce qui conduit à une perte de matière conséquente.

De plus, lorsque la couche épaisse est ensuite utilisée comme substrat donneur pour le transfert d'une couche mince suivant la technologie Smart-Cut®, une zone d'exclusion se forme à nouveau du fait de la tombée de bord. Le substrat obtenu présente finalement une couronne de manque de matière très importante, ce qui limite son utilisation.

Le document US 6 974 760 décrit ce phénomène et divulgue un procédé de transfert de couche mince dont les doses et l'énergie d'implantation sont paramétrées pour que la matière sur le substrat donneur correspondant à cette zone d'exclusion soit réduite et exfoliée au moment du détachement. Le substrat donneur est alors plus facilement recyclé.

Cependant, avec ou sans procédé de transfert spécifique, il subsiste toujours une zone d'exclusion en périphérie de la couche transférée. Pour obtenir une couche transférée ayant un diamètre équivalent à celui d'un substrat normalisé, il faut utiliser des substrats supports et des substrats donneurs ayant des diamètres plus importants que le diamètre que l'on souhaite obtenir pour la couche à transférer. Toutefois, en outre du surcoût de matière, les appareils de traitement utilisés lors de la fabrication de ce type de structures composites ne sont adaptés que pour recevoir des plaques (wafer) ayant des diamètres spécifiques (normalisés), comme par exemple des plaques de 200 mm de diamètre. Ces appareils ne sont en général pas réglables pour d'autres diamètres.

Par ailleurs, le chauffage nécessaire pour renforcer le collage du substrat support avec le substrat donneur fragilisé ne doit pas provoquer la fracture avant que l'assemblage ne soit suffisamment collé. Dans ce cas, la fracture risque, en effet, d'être partielle ou moins précise. En vue d'obtenir une adhésion suffisante malgré cette obligation de collage à faible température, les surfaces à coller doivent être parfaitement planes et leurs rugosités fortement polies pour obtenir un bon contact et une adhérence maximale. Cela augmente encore le coût de fabrication notamment dans le cas de matériaux durs tels que le SiC ou le GaN.

### Résumé de l'invention

L'invention a pour but de remédier aux inconvénients précités et de proposer une structure qui permet la croissance épitaxiale de couches épaisses de matériaux semi-conducteurs, notamment de type III/N, III/V et IV, ces couches ayant un diamètre déterminé correspondant au diamètre initial de la couche de croissance, et ce même en utilisant des plaques présentant un chanfrein ou une zone de tombée de bord en périphérie.

Ce but est atteint avec un procédé de fabrication d'une structure composite pour épitaxie comprenant au moins une couche de germe cristallin de croissance de matériau semi-conducteur sur un substrat support, le substrat support et la couche de germe cristallin de croissance présentant à la périphérie de leur face de collage un chanfrein ou une zone de tombée de bord, caractérisé en ce que le procédé comprend au moins une étape de collage par adhésion moléculaire de la couche de germe cristallin de croissance sur le substrat support et au moins une étape d'amincissement de la couche de germe cristallin de croissance, ladite couche de germe cristallin de croissance présentant un diamètre après amincissement identique à son diamètre initial.

Ainsi, le procédé de l'invention permet d'obtenir un substrat de croissance permettant de former des couches épitaxiées sans perte de diamètre par rapport à un substrat de croissance réalisé selon la technologie Smart-CutⓇ. En effet, contrairement à la réalisation d'une telle structure composite selon la technologie Smart-Cut®, la structure composite selon le procédé de l'invention est réalisée sans transfert de couche de germe de croissance, ce qui permet d'éviter l'apparition d'une zone d'exclusion à la périphérie de cette dernière et de disposer ainsi directement d'une couche de germe de croissance d'un diamètre déterminé correspondant au diamètre initial de la plaque utilisée pour former la couche de germe. Les couches épaisses de matériau semi-conducteur obtenues à partir de cette couche de germe auront, par conséquent, aussi le même diamètre déterminé.

En outre, puisque le procédé de l'invention n'entraîne pas de zone d'exclusion en périphérie de la couche de germe, la structure composite peut être directement formée avec une couche de germe et un substrat support ayant un diamètre normalisé en utilisant les appareils de traitement habituels.

En particulier, avec le procédé de l'invention, il est possible de former une structure composite pour épitaxie comprenant une couche de germe cristallin de croissance et un substrat support qui présentent tous les deux le même diamètre, et ce avant et après la fabrication de la structure, en particulier avant et après l'étape d'amincissement de la couche de germe cristallin de croissance

Selon un aspect de l'invention, l'épaisseur de la couche de germe cristallin de croissance retirée est choisie de manière à ce que ladite couche de germe cristallin de croissance présente après amincissement une épaisseur finale qui est, d'une part, inférieure à celle sur laquelle s'étend le chanfrein ou la tombée de bord supérieur de la couche et, d'autre part, supérieure à celle sur laquelle s'étend le chanfrein inférieur ou la tombée de bord de la couche.

La couche de germe, même une fois amincie, reste plus épaisse que celle obtenue par transfert avec la technologie Smart-Cut®. La couche présente alors une plus grande résistance mécanique que celle obtenue par transfert Smart-Cut®, ce qui la rend moins friable au cours des diverses manipulations et réduit, par conséquent, le risque de contamination du reste de la structure ou de la croissance ultérieure. La couche de germe cristallin de croissance est amincie jusqu'à une épaisseur finale comprise entre 5 et 100 µm, de préférence 50 µm environ.

Le substrat support peut être constitué notamment d'un matériau choisi parmi au moins un des matériaux suivants: AIN polycristallin, GaN monocristallin ou polycristallin, SiC monocristallin ou polycristallin, du saphir, une céramique telle qu'un oxyde d'aluminium ou alumine, ou encore un alliage métallique tel qu'un alliage de Mo, Cr et Ni de type Hastelloy dont les proportions des différents métaux sont choisies pour que l'alliage présente un coefficient de dilatation thermique proche de celui du matériau à épitaxier.

La couche de germe cristallin de croissance de matériau semi-conducteur peut être constituée notamment d'un matériau choisi parmi au moins un des matériaux suivants: Si monocristallin tel que le Si (1, 1, 1), SiC monocristallin, saphir monocristallin, un matériau III/N ou III/V binaire, ternaire ou quaternaire. Ces matériaux peuvent être utilisés pour la croissance épitaxiale de matériaux III/N tels que du nitrure de gallium (GaN). Certains d'entre eux, comme par exemple le Si, peuvent en outre être utilisés pour la croissance épitaxiale de matériaux de la colonne IV tels que le germanium ou de matériaux III/V tels que du GaAs.

Selon un aspect de l'invention, le procédé peut comprendre, avant l'étape de collage, une étape de formation d'une couche de collage, par exemple une couche d'oxyde, sur la face de collage du substrat support et/ou sur la face de collage de la couche de germe cristallin de croissance de matériau semi-conducteur.

Selon un autre aspect de l'invention, le procédé de l'invention comprend une étape d'activation des surfaces de collage, soit du substrat support et de la couche de croissance directement, soit des couches de collage, par traitement plasma.

L'étape de collage consiste à placer les surfaces en contact intime à température ambiante. Un ou plusieurs recuits de stabilisation pour renforcer le collage peuvent être réalisés à une température comprise entre 100°C et 1000°C environ. Un recuit de stabilisation est notamment réalisé à une température comprise entre 200°C et 500°C environ sur une durée d'au moins une heure. Dans la mesure où le budget thermique (couple température/temps) pour réaliser le collage n'est pas limité comme c'est le cas avec la technologie Smart-Cut® pour empêcher la fracture, il est moins important de disposer de plaques qui soient parfaitement planes et d'une rugosité particulièrement faible. La rugosité des faces des plaques à coller peut en effet se situer dans l'ordre du micron RMS lorsque qu'une couche de collage est utilisée. Ceci implique une finition moins coûteuse. Le coût de fabrication de la structure composite est donc réduit, ce qui est d'autant plus avantageux que cette structure composite n'a qu'une utilité éphémère. En effet, la structure composite ne se retrouve pas dans les dispositifs ultérieurs et la couche de germe est détruite après formation du matériau semi-conducteur épitaxié.

Selon un aspect particulier de l'invention, l'amincissement de la couche de germe cristallin de croissance peut être réalisé en plusieurs étapes en réalisant un recuit de stabilisation du collage entre deux étapes d'amincissement consécutives, chaque recuit de stabilisation étant effectué à une température croissante, c'est-à-dire à une température supérieure à celle du recuit précédent. Les étapes d'amincissement et de recuit sont répétées jusqu'à l'obtention d'une épaisseur de couche de germe et d'une force de collage désirées.

L'invention concerne également un procédé de réalisation d'une couche de matériau semi-conducteur, notamment de type III/V, III/N et IV, comprenant la croissance épitaxiale d'une couche de matériau semi-conducteur sur une structure composite comprenant une couche de germe cristallin de croissance, la structure composite étant réalisée conformément au procédé de fabrication décrit précédemment.

Selon un aspect de l'invention, la croissance épitaxiale est réalisée pendant une durée déterminée correspondant à la formation d'une couche de matériau semi-conducteur ayant une épaisseur suffisante pour être autoportée seule, à savoir une épaisseur d'au moins 100 µm. En variante, la couche de germe cristallin de croissance peut être conservée avec la couche de matériau semi-conducteur épitaxiée pour former une structure autoportée qui peut être utilisée pour une reprise d'épitaxie. Dans ce cas, la croissance épitaxiale de la couche de matériau semi-conducteur est réalisée pendant une durée déterminée permettant d'obtenir une épaisseur cumulée de couche de germe et de couche de semi-conducteur d'au moins 100 µm.

Le procédé de réalisation d'une couche de matériau semi-conducteur peut comprendre en outre, avant la croissance épitaxiale d'une couche de matériau semi-conducteur, la formation d'une couche de nucléation sur la couche de germe cristallin de croissance. Cette couche de nucléation joue le rôle d'une couche tampon qui permet d'améliorer la qualité cristalline du matériau semi-conducteur épitaxié.

Le procédé de réalisation d'une couche de matériau semi-conducteur peut comprendre en outre une ou plusieurs des étapes suivantes:
- après la croissance épitaxiale de la couche de matériau semi-conducteur, retrait du substrat support et de la couche de germe cristallin de croissance, avec éventuellement la couche de nucléation (cas de la couche de semi-conducteur autoportée),
- après la croissance épitaxiale de la couche de matériau semi-conducteur, retrait du substrat support (cas de la structure autoportée couche de germe/couche de semi-conducteur),
- un rodage double face de la couche de matériau semi-conducteur autoportée de manière à obtenir une flèche inférieure à 50 micromètres, une étape de polissage de la face exposée par le retrait pour diminuer sa rugosité et la zone potentiellement écrouie et une étape de retrait d'une portion périphérique de la couche de matériau semi-conducteur de manière à obtenir une densité de dislocation moyenne dans ladite couche de matériau semi-conducteur inférieure 10⁶/cm².
   L'invention vise encore une structure multicouche comprenant une structure composite comprenant au moins une couche de germe cristallin de croissance de matériau semi-conducteur sur un substrat support, la couche de germe cristallin de croissance ayant un diamètre identique au diamètre du substrat support et une épaisseur d'au moins 5 µm.
   Une telle structure ne peut être obtenue avec les procédés de l'art antérieur car, comme expliqué précédemment, avec les procédés connus, il subsiste toujours une zone d'exclusion en périphérie de la couche transférée.
   La structure multicouche peut comprendre en outre une couche de matériau semi-conducteur formée par croissance épitaxiale sur la couche de germe cristallin de croissance selon le procédé de réalisation d'une couche de matériau semi-conducteur décrit précédemment.
   Selon un aspect de l'invention, la couche de matériau semi-conducteur présente une épaisseur d'au moins 100 µm suffisante pour être autoportée seule. Elle peut aussi présenter une épaisseur permettant de former une structure couche de germe/couche de semi-conducteur d'au moins 100 µm d'épaisseur, c'est-à-dire autoportée.

### Brève description des figures

- les figures 1A à 1C, déjà décrites, sont des vues schématiques en coupe montrant la réalisation d'une structure composite pour épitaxie selon l'art antérieur,
- les figures 2A à 2G sont des vues schématiques en coupe montrant la réalisation d'une structure composite pour épitaxie conformément à un mode de mise en oeuvre de l'invention,
- la figure 3 est un organigramme des étapes mises en oeuvre dans les figures 2A à 2G.

### Exposé détaillé de modes de réalisation de l'invention

La présente invention s'applique d'une manière générale à la réalisation de couches de matériau semi-conducteurs, en particulier des matériaux III/V, III/N et IV, par épitaxie sous forme de plaques (wafers), ces couches présentant directement après leur formation par épitaxie un diamètre déterminé de plaque. A cet effet, la présente invention propose un procédé de réalisation d'une structure composite pour épitaxie à partir de plaques comprenant un chanfrein ou une zone de "tombée de bord" ("edge rounding") et qui permet néanmoins de réaliser des couches de matériau semi-conducteur épitaxiées sans perte de diamètre par rapport au diamètre initial de la plaque utilisée pour former la couche de germe cristallin de croissance. Comme décrit ci-après, la structure composite pour épitaxie selon l'invention comprend au moins un substrat support et une couche de germe cristallin de croissance de matériau semi-conducteur.

Le matériau du substrat support peut être choisi de manière à présenter un coefficient de dilatation thermique (CTE) proche de celui du matériau semi-conducteur qui doit être formé par épitaxie à partir de la structure composite afin d'éviter l'apparition de fissures dans ce dernier au cours du refroidissement et lorsque l'épaisseur de la couche épitaxiée dépasse une épaisseur seuil.

Le matériau du substrat support peut être de l'AIN polycristallin moins onéreux que l'AIN monocristallin, du SiC monocristallin ou polycristallin, un alliage métallique tel que de l'Hastelloy (alliage de Cr, Mo et Ni), du saphir, de la céramique telle que l'oxyde d'aluminium aussi appelé alumine Al₂O₃ ou tout autre matériau bon marché dont le coefficient de dilatation thermique est adapté à celui du matériau semi-conducteur à épitaxier. Dans le cas d'une épitaxie de nitrure de gallium (GaN), le support est choisi de préférence parmi le GaN polycristallin ou monocristallin et le nitrure d'aluminium (AIN) polycristallin. L'AIN polycristallin étant une céramique, on peut ajuster son coefficient de dilatation thermique lors de sa fabrication pour correspondre à celui du GaN.

Le matériau de la couche de germe cristallin de croissance est monocristallin. Il est choisi de manière à permettre la croissance d'un matériau semi-conducteur avec une densité de défauts inférieure à 10⁹/cm² et de préférence inférieure à 10⁶/cm² en face arrière, par exemple de 10⁴/cm² pour le matériau de germanium. La face arrière de la couche de matériau semi-conducteur épitaxié correspond à la face qui était en contact avec la couche de germe mais qui a pu subir un amincissement lors de la préparation finale de la couche pour un usage ultérieur. Cette face comporte la densité de défauts la plus importante de la couche de matériau semi-conducteur, car au cours de la croissance, la défectivité de la couche formée par épitaxie tend à décroître. Pour le GaN dont la croissance est effectuée selon l'axe c de la structure cristallographique wurzite, il s'agit typiquement de la face de polarité N.

Dans le cas de la formation de la couche de matériau semi-conducteur par homoépitaxie, il suffit que la couche de germe présente en surface une densité de défauts inférieure à 10⁹/cm² et de préférence inférieure à 10⁶/cm². Dans le cas de la formation de la couche de matériau semi-conducteur par hétéroépitaxie, le matériau de la couche de germe est choisi avec un paramètre de maille et une qualité cristalline permettant la croissance d'une couche de matériau semi-conducteur avec une densité de défauts inférieure à 10⁹/cm² et de préférence inférieure à 10⁶/cm² en face arrière.

Le matériau de la couche de germe cristallin peut aussi être choisi pour présenter un coefficient de dilatation thermique qui soit proche de celui du substrat support sachant que l'influence du coefficient de dilatation thermique de la couche de germe est plus importante lorsque son épaisseur n'est plus négligeable devant celle du substrat support. Ainsi, la structure restera stable au cours des variations de température auxquelles elle sera soumise. Par ailleurs, le recuit de stabilisation de collage de la couche de germe et du substrat support pourra être effectuée à une température d'autant plus élevée que la différence de coefficient de dilatation thermique entre les matériaux sera faible.

La couche de germe cristallin de croissance peut être notamment constituée de saphir (Al₂O₃), de silicium monocristallin par exemple du Si (1,1,1),de SiC monocristallin adapté par exemple pour l'épitaxie de GaN ou de matériaux III/V ou III/N binaire, ternaire ou quaternaire monocristallin. La rugosité de la face préparée à l'épitaxie est de quelques angströms RMS.

De façon bien connue, en fonction de la nature de la couche de germe cristallin de croissance, divers matériaux binaires, ternaires ou quaternaires à base de matériaux semi-conducteurs III/V ou III/N peuvent être formés. La structure composite pour épitaxie de l'invention est notamment destinée à permettre la croissance épitaxiale de GaN, InGaN, AlGaN, AlGaInN et de nitrure d'indium InN.

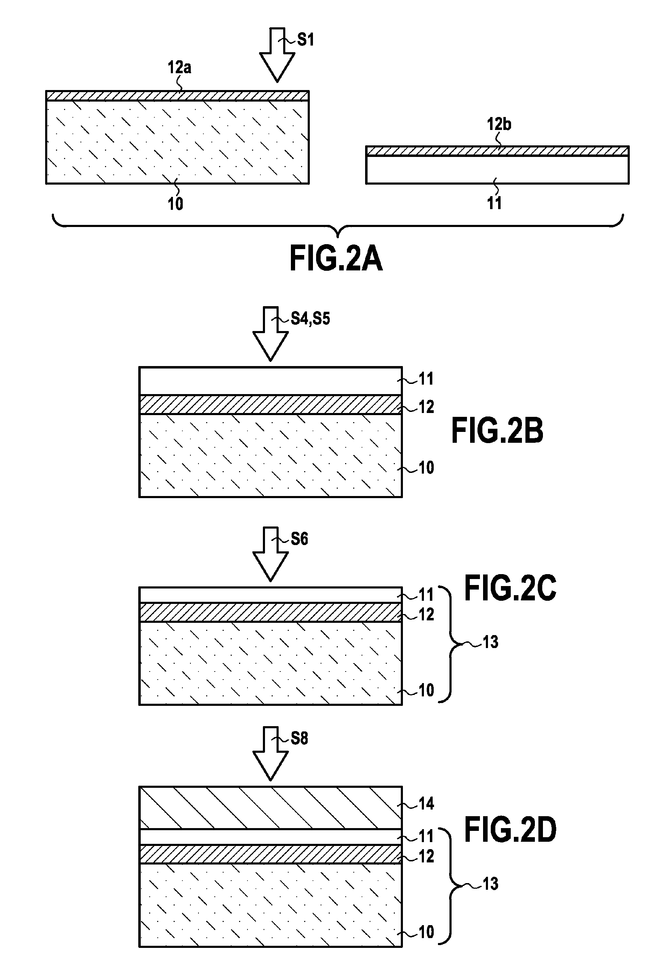

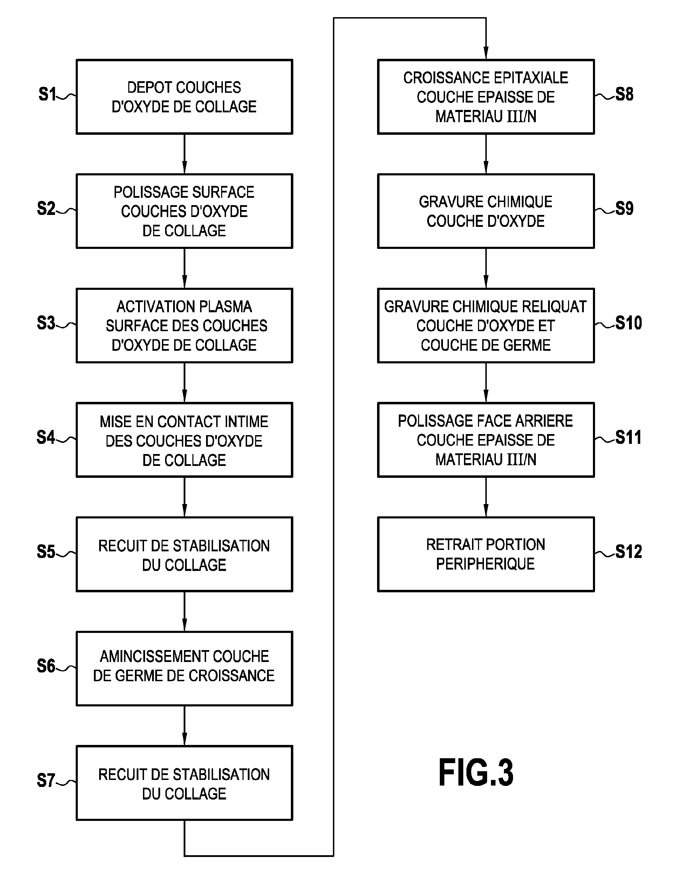

Un procédé de fabrication d'une structure composite suivi d'un procédé de réalisation d'une couche de matériau semi-conducteur, ici un matériau III/N, par épitaxie conformément à un mode de réalisation de l'invention est maintenant décrit en référence aux figures 2A à 2G et 3. Bien que ce ne soit pas représenté sur les figures 2A à 2G, le substrat support ainsi que la couche de germe cristallin de croissance présente chacun sur leurs deux surfaces un chanfrein ou une "tombée de bord" conformément aux normes SEMI^{™} comme illustré de façon volontairement exagérée sur les figures 1A à 1C.

La réalisation de la structure composite pour épitaxie débute par le collage d'un substrat support avec une couche de germe cristallin de croissance. Ce collage est réalisé par adhésion moléculaire soit directement entre ces deux éléments, soit par l'intermédiaire de couches de collage.

Le principe du collage par adhésion moléculaire est bien connu en soi et ne sera pas décrit plus en détail. Pour rappel, le collage par adhésion moléculaire est basé sur la mise en contact intime de deux surfaces, c'est-à-dire sans utilisation d'un matériau spécifique (colle, cire, métal à basse température de fusion, etc.), les forces attractives entre les deux surfaces étant assez élevées pour provoquer l'adhérence moléculaire (collage induit par l'ensemble des forces attractives (forces de Van Der Waals) d'interaction électronique entre atomes ou molécules des deux surfaces à coller).

Dans le mode de réalisation présenté ici, on procède à un dépôt d'une couche de collage à la fois sur une face d'un substrat support 10 et sur une face d'une couche de germe cristallin de croissance 11 de matériau III/N (étape S1, figure 2A). Dans l'exemple ici décrit, le substrat support 10 est en nitrure d'aluminium polycristallin (AIN) et la couche de germe cristallin de croissance 11 est en saphir (Al₂O₃). Le substrat support et la couche de germe de croissance présentent chacun une rugosité de surface de 1 µm.

Les couches de collage 12a et 12b utilisées dans le présent exemple sont des couches d'oxyde de collage respectivement déposées sur le substrat support 10 et la couche de germe cristallin de croissance 11. Plus précisément, les couches 12a et 12b sont ici des couches d'oxyde de silicium (SiO₂) formées par dépôt chimique en phase vapeur à basse pression (LPCVD) ou par dépôt chimique en phase vapeur assisté par plasma (PECVD). Toutefois, les couches de collage peuvent être aussi des couches de diamant, de verre type SOG ("Spin On Glass"), de l'AIN, du nitrure de silicium tel que le Si₃N₄, ou encore des couches d'oxyde BPSG ("Boro-Phospho-Silicate Glass") (l'oxyde BPSG est bien connu de l'homme du métier comme étant un verre de silicate dopé au bore et au phosphore). Dans le cas de l'utilisation de deux couches de collage, il peut être avantageux de choisir des matériaux de collage différents pour obtenir une meilleure adhésion. Par exemple, on peut déposer une couche de Si₃N₄ sur une couche de germe en GaN qui sera collée à un substrat support en saphir recouvert d'une couche d'oxyde de silicium. La ou les couches de collage présentent une épaisseur comprise entre quelques dizaines de nanomètres et 10 µm environ.

Lorsque les couches de collage 12a et 12b sont des oxydes, un recuit de densification de l'oxyde, avant le collage, à une température plus élevée que celle de dépôt, peut être réalisé pour augmenter la force de collage entre la couche de germe cristallin et le substrat support si nécessaire.

La surface des couches d'oxyde de collage 12a et 12b est aplanie par polissage mécano-chimique (CMP) pour obtenir une rugosité de surface inférieure à 5 Å RMS et faciliter ainsi la mise en contact intime ultérieure (étape S2).

On peut ensuite procéder à un collage de type plasma du substrat support 10 avec la couche de germe cristallin de croissance 11 par mise en contact intime des couches d'oxyde de collage 12a et 12b et par un recuit de stabilisation à 500°C appliqué pendant une durée de 2 heures environ (figure 2B, étapes S4 et S5). Le collage est de type plasma, ce qui signifie que les surfaces des couches d'oxyde de collage 12a et 12b ont été traitées au plasma (étape S3) préalablement avant leur mise en contact intime. Le traitement par plasma permet notamment d'activer la surface de collage des couches 12a et 12b de manière à accroître leur capacité d'adhérence. Ainsi, la surface des couches 12a et 12b peut être exposées à des plasmas à base d'oxygène, d'azote, d'argon ou autres.

Les équipements utilisés à cet effet peuvent être notamment des équipements initialement prévus pour des gravures ioniques réactives RIE (acronyme anglo-saxon de "Reactive Ion Etching") à couplage capacitif, ou à couplage inductif ICP (acronyme anglo-saxon de "Inductively Coupled Plasma"). Pour plus de précisions, on pourra par exemple se référer au document de Sanz-Velasco et Coll. intitulé "Room température wafer bonding using oxygen plasma treatment in reactive ion etchers with and without inductively coupled plasma" (Journal of Electrochemical Society 150, G155, 2003).

D'autres équipements à plasma atmosphérique, ou encore munis d'une source de type ECR (abréviation anglo-saxonne de "Electron Cyclotron Resonance") ou de type helicon peuvent également être utilisés.

Dans la pratique, l'activation de collage par plasma comprend en général au préalable un nettoyage chimique, tel qu'un nettoyage RCA, suivi d'un polissage mécano-chimique pour lisser la rugosité éventuelle puis de l'exposition de la surface avec un plasma pendant quelques secondes à quelques minutes.

Les étapes de traitement (S2 à S5) décrites précédemment peuvent bien entendu être également réalisées avec des couches de collage autres que des oxydes et en particulier avec des couches de collage constituées de diamant, d'AIN ou de nitrure de silicium.

Dans le cas d'un collage entre le substrat support et la couche de germe cristallin de croissance sans couche de collage, les surfaces de collage de ces deux éléments peuvent être elles aussi préalablement activées par plasma comme décrit précédemment. Le collage entre ces deux éléments peut être un collage hydrophile ou hydrophobe suivant la nature des matériaux utilisés.

Comme représentée sur la figure 2B, on obtient après collage une structure composite comprenant le substrat support 10, une couche d'oxyde 12 correspondant aux couches d'oxyde de collage 12a et 12b et la couche de germe cristallin de croissance 11.

La couche de germe cristallin de croissance 11 est amincie jusqu'à une épaisseur de 50 µm (étape S6, figure 2C). Cet amincissement peut être réalisé par rodage et/ou polissage mécanique et/ou par gravure chimique de la face exposée de la couche de germe cristallin de croissance 11. La surface de la couche de germe cristallin 11 peut ensuite être préparée à l'épitaxie par un polissage mécano-chimique (CMP). La couche de germe cristallin de croissance 11 présente après amincissement une épaisseur finale qui est, d'une part, inférieure à celle sur laquelle s'étend le chanfrein ou la tombée de bord supérieur de la couche et, d'autre part, supérieure à celle sur laquelle s'étend le chanfrein inférieur ou la tombée de bord de la couche. Conformément à l'invention, cela permet d'éviter une réduction de diamètre de la couche 11 ainsi que les risques d'écaillage de cette couche mécaniquement fragile. D'une manière générale, l'épaisseur finale de la couche de germe cristallin de croissance est comprise entre 5 et 100 µm environ, de préférence 50 µm.

Ainsi, en évitant toute réduction de diamètre de la couche de germe lors de la fabrication de la structure pour épitaxie, il est possible de déterminer au départ le diamètre de la couche épitaxiée formée ultérieurement puisque celle-ci aura le même diamètre que la couche de germe cristallin de croissance. Cela permet notamment de réaliser, comme illustré sur les figures 2A à 2C, une structure pour épitaxie à partir d'une couche de germe cristallin 11 et d'un substrat support 10 ayant le même diamètre initial, le substrat support et la couche de germe présentant toujours le même diamètre même après l'étape d'amincissement de la couche de germe. Dans le cas, par exemple, où l'on désire obtenir des couches épitaxiées ayant un diamètre normalisé (par exemple 100 mm, 200 mm ou 300 mm), il suffit de réaliser une structure pour épitaxie selon l'invention avec une couche de germe formée à partir d'une plaque ayant le diamètre normalisé visé.

Comme illustré sur la figure 2C, on obtient alors une structure composite pour épitaxie 13 comprenant le substrat support 10, une couche d'oxyde de collage 12 (SiO₂) et la couche de germe cristallin de croissance amincie 11. La structure composite 13 peut en outre être soumise à un second recuit de stabilisation du collage réalisé à une température de 900 °C pendant 1 heure environ (étape S7).

L'amincissement de la couche de germe peut également être réalisé en plusieurs étapes entre lesquelles des recuits de stabilisation de collage peuvent être effectués pour améliorer la force du collage de la structure composite. Par exemple, après le premier recuit de stabilisation de collage à 200°C, l'amincissement de la couche de germe est réalisé jusqu'à une épaisseur déterminée, par exemple 500 micromètres, puis un autre recuit de stabilisation est réalisé à 300°C pendant une heure. Il est ensuite procédé à une deuxième étape d'amincissement jusqu'à une épaisseur de 400 micromètres et un autre recuit de stabilisation est effectué à une température supérieure à celle du précédent recuit, par exemple à 400°C. Ces étapes peuvent être reproduites jusqu'à ce que la force de collage et l'épaisseur de la couche de germe souhaitées soient atteintes.

La suite de la description concerne les étapes mises en oeuvre pour la réalisation d'une couche de matériau monocristallin III/N par épitaxie à partir de la couche de germe cristallin de croissance 11 de la structure composite 13.

La couche de matériau III/N formée par épitaxie doit être d'une épaisseur suffisante pour être autoportée, c'est-à-dire pour former une couche qui se tient toute seule sans support mécanique ou raidisseur. A cet effet, la croissance épitaxiale est effectuée jusqu'à ce que la couche de matériau III/N présente une épaisseur comprise entre 100 µm et 1 mm, de préférence entre 500 µm et 1 mm.

La croissance de la couche de matériau III/N est réalisée au moins en partie par épitaxie en phase de vapeurs d'hydrure (connue de l'homme du métier sous l'acronyme HVPE de l'expression anglo-saxonne "Hydride Vapor Phase Epitaxy"). Ce type d'épitaxie est effectué à une température comprise entre 700°C et 1100°C.

La croissance épitaxiale est poursuivie jusqu'à atteindre une épaisseur suffisante pour que la couche de matériau III/N soit ultérieurement autoportée, lorsqu'elle sera séparée du substrat support 10.

La façon de réaliser une telle épitaxie, les paramètres et les orientations respectives de la couche de germe cristallin de croissance et de la couche épaisse de matériau III/N sont connus de l'homme du métier. Le plan cristallographique de la couche de germe déterminant celui du matériau épitaxié, il est possible d'obtenir des matériaux qui soient polaire, non polaire, ou semi polaire en choisissant l'orientation cristalline de la couche de germe ce qui est parfois souhaité pour le GaN.

Selon une variante de réalisation de l'invention, il est également possible de procéder avant la croissance de ladite couche épaisse de matériau III/N, à une étape de croissance par épitaxie d'une couche de nucléation (non représentée sur les figures), réalisée dans le même matériau que celui de la couche de germe cristallin de croissance et/ou que celui utilisé ultérieurement pour la réalisation de la couche épaisse de matériau III/N. Toutefois, cette couche de nucléation peut aussi être d'une nature différente de celle de la couche épaisse de matériau III/N et/ou de la couche de germe. On peut, par exemple, déposer une couche de nucléation d'AIN sur une couche de germe de carbure de silicium (SiC) avant la croissance épitaxiale d'une couche épaisse de GaN. La couche de nucléation sur la couche de germe joue un rôle de tampon et permet d'améliorer la qualité cristalline de la couche épaisse de matériau III/N formée ultérieurement. La couche de nucléation présente une épaisseur comprise entre 10 nm et 10 µm.

Dans ce cas, et notamment pour le GaN, l'épitaxie de cette couche de nucléation peut être réalisée par un dépôt chimique en phase vapeur organo-métallique (connue de l'homme du métier sous l'acronyme "MOCVD", de l'expression anglo-saxonne "Metal Organic Chemical Vapor Déposition") ou par épitaxie par jet moléculaire (connue de l'homme du métier sous l'acronyme "MBE", de l'expression anglo-saxonne "Molecular Beam Epitaxy").

Il est également possible d'utiliser des techniques de croissance latérale (connues de l'homme du métier sous l'acronyme "ELOG", de l'expression anglo-saxonne "Epitaxial Latéral Over Growth").

Dans le mode de mise en oeuvre décrit ici, une croissance épitaxiale d'une couche de GaN est réalisée sur la couche de germe cristallin de croissance 11 en Al₂O₃ par HVPE à une température de 800°C et pendant une durée suffisante pour former une couche de GaN 14 d'une épaisseur de 1 mm environ (étape S8, figure 2D).

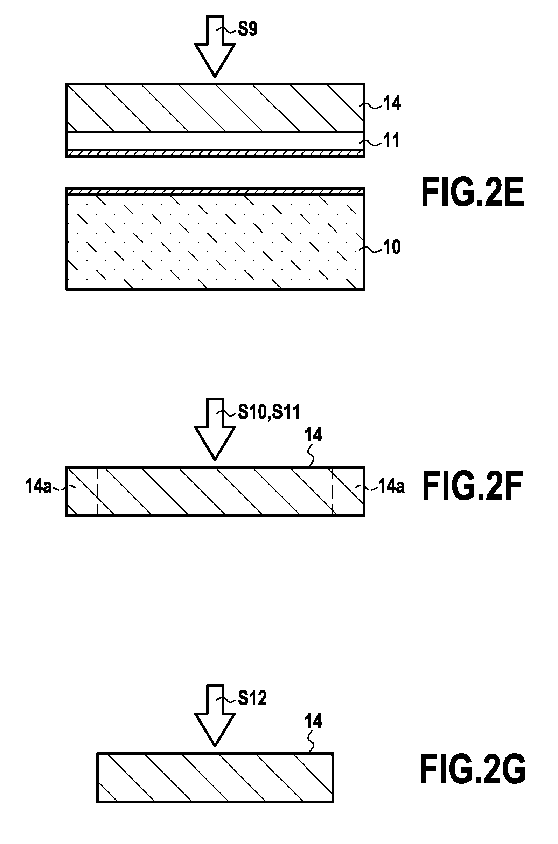

Lorsque la couche de collage 12 est en oxyde, elle est ensuite gravée chimiquement, par exemple avec une solution HF, pour détacher le substrat support 11 du reste de la structure (étape S9, figure 2E).

L'oxyde résiduel et la couche de germe cristallin de croissance 11 subsistant sur la couche de GaN 14 sont gravés chimiquement pour être éliminés (étape S10, figure 2F). Les techniques de gravure chimique pour retirer de tels matériaux sont bien connues de l'homme du métier.

La couche de germe cristallin de croissance, et éventuellement le substrat support dans le cas où il n'y a pas de couche d'oxyde de collage, peuvent aussi être retirés mécaniquement par polissage.

La couche de GaN autoportée est polie par un rodage double face afin de corriger la planéité et/ou d'éliminer une zone susceptible de présenter une déformation de type "flèche" ("wafer bow") trop importante pour un usage ultérieur. Il s'agit de polir les deux faces du matériau simultanément jusqu'à obtenir une flèche inférieure à 50 micromètres (le parallélisme de surfaces maximal est atteint avec une flèche de 15 micromètres). Une étape de polissage de la face arrière est ensuite nécessaire pour réduire la rugosité de la surface à une valeur inférieure à 5 angströms de manière par exemple à pouvoir être collée dans une utilisation ultérieure (étape S11, figure 2F). Ce polissage permet aussi de réduire la densité de défauts en face arrière jusqu'à un taux de dislocation utile désiré comme par exemple inférieur à 10⁷/cm² et de préférence inférieur à 10⁶/cm². Ce polissage permet enfin l'enlèvement de la zone sous la surface potentiellement écrouie par l'étape de rodage double face.

Une portion périphérique 14a de la couche de GaN autoportée 14 comprenant par nature une densité de défauts très importante et éventuellement des fissures peut être également retirée pour que la couche présente au final une densité maximale de défauts de 10⁶/cm² (étape S12, figure 2G).

On procède aussi à un ajustement pour former des chanfreins ou tombées de bords sur les deux surfaces de la couche au voisinage de sa périphérie.

Selon une autre variante de réalisation de l'invention, une épitaxie est réalisée sur la structure composite préparée à l'épitaxie jusqu'à obtenir une fine couche de matériau dont l'épaisseur est telle que l'ensemble de la couche de germe et de la couche de semi-conducteur formée par épitaxie puisse être autoporté. L'épaisseur cumulée de la couche de semi-conducteur épitaxié et de la couche germe est comprise entre 100 µm et 1 mm, de préférence entre 500 µm et 1 mm. Dans ce cas, seul le substrat support est retiré. La structure ainsi obtenue est utilisée pour une reprise d'épitaxie, dans le même matériau que celui de la fine couche, jusqu'à l'épaisseur souhaitée. Il est également envisageable d'utiliser un matériau différent. L'avantage de cette variante de réalisation de l'invention réside en ce que la reprise d'épitaxie est affranchie des contraintes d'adaptation de coefficient thermique liées à la nature du support.

La structure composite pour épitaxie selon l'invention peut être réalisée avec un substrat support et une couche de germe cristallin ayant le même diamètre comme décrit précédemment ou avec un substrat support ayant un diamètre différent de celui de la couche de germe cristallin de croissance puisque c'est le diamètre de cette dernière qui détermine celui de la couche de semi-conducteur à former par épitaxie. Lorsque la couche épitaxiée est suffisante pour être autoportée, les étapes de finition, dont le retrait de la portion périphérique, permettent d'adapter son diamètre si nécessaire.

Le procédé de l'invention n'est pas non plus limité à la réalisation de couches de matériaux semi-conducteurs autoportées. La structure composite pour épitaxie obtenue selon le procédé de l'invention peut aussi être utilisée pour la croissance de couches minces qui sont destinées à être transférées sur un substrat final aux propriétés spécifiques. La structure composite de l'invention peut encore être utilisée pour la croissance d'un empilement de couches minces de différents matériaux semi-conducteurs qui pourra être autoporté.

## Revendications

1. Procédé de fabrication d'une structure composite pour épitaxie comprenant au moins une couche de germe cristallin de croissance (11) de matériau semi-conducteur sur un substrat support (10), le substrat support (10) et la couche de germe cristallin de croissance (11) présentant à la périphérie de leur face de collage un chanfrein ou une zone de tombée de bord, **caractérisé en ce que** ledit procédé comprend au moins une étape de collage par adhésion moléculaire de la couche de germe cristallin de croissance (11) sur le substrat support (10) et au moins une étape d'amincissement de la couche de germe cristallin de croissance (11), ladite couche de germe cristallin de croissance présentant un diamètre après amincissement identique à son diamètre initial.

2. Procédé selon la revendication 1, **caractérisé en ce que**, lors de l'étape d'amincissement, l'épaisseur de la couche de germe cristallin de croissance (11) retirée est choisie de manière à ce que l'épaisseur finale de ladite couche de germe cristallin de croissance présente une épaisseur supérieure à celle sur laquelle s'étend le chanfrein ou la zone de tombée de bord.

3. Procédé selon la revendication 2, **caractérisé en ce que** la couche de germe cristallin de croissance (11) est amincie jusqu'à une épaisseur finale comprise entre 5 et 100 µm.

4. Procédé selon l'une quelconque des revendications 1 à 3, **caractérisé en ce que** la couche de germe cristallin de croissance (11) présente en surface une densité de défauts inférieure à 10⁹/cm².

5. Procédé selon l'une quelconque des revendications 1 à 4, **caractérisé en ce que** le substrat support (10) est constitué d'un matériau choisi parmi au moins un des matériaux suivants: AIN polycristallin, GaN monocristallin ou polycristallin, SiC monocristallin ou polycristallin, du saphir, une céramique, un alliage métallique.

6. Procédé selon la revendication 5, **caractérisé en ce que** la couche de germe cristallin de croissance (11) de matériau semi-conducteur est constituée d'un matériau choisi parmi au moins un des matériaux suivants: Si monocristallin, SiC monocristallin, saphir monocristallin, un matériau III/N ou III/V binaire, ternaire ou quaternaire.

7. Procédé selon l'une quelconque des revendications 1 à 6, **caractérisé en ce qu'**il comprend, avant l'étape de collage, une étape de formation d'une couche de collage (12a) sur la face de collage du substrat support (10) et/ou d'une couche de collage (12b) sur la face de collage de la couche de germe cristallin de croissance (11) de matériau semi-conducteur.

8. Procédé de réalisation d'une couche de matériau semi-conducteur comprenant la croissance épitaxiale d'une couche de matériau semi-conducteur (14) sur une structure composite (13) comprenant une couche de germe cristallin de croissance (11), la structure composite (13) étant réalisée conformément au procédé de fabrication selon l'une quelconque des revendications 1 à 7.

9. Procédé selon la revendication 8, **caractérisé en ce que** la croissance épitaxiale est réalisée pendant une durée déterminée de manière à obtenir une épaisseur cumulée de la couche de matériau semi-conducteur et de la couche de germe cristallin de croissance d'au moins 100 µm.

10. Procédé selon la revendication 8 ou 9, **caractérisé en ce qu'**il comprend en outre une étape de retrait du substrat support (10) et une étape de retrait de la couche de germe cristallin de croissance (11).

11. Procédé selon la revendication 10, **caractérisé en ce qu'**il comprend en outre, après l'étape de retrait du substrat support (10) et de la couche de germe cristallin de croissance (11), une étape de rodage double face de la couche de matériau semi-conducteur (14) de manière à obtenir une flèche inférieure à 50 micromètres, une étape de polissage de la face exposée après ledit retrait et une étape de retrait d'une portion périphérique (14a) de la couche de matériau semi-conducteur (14).

12. Procédé selon l'une quelconque des revendications 9 à 11, **caractérisé en ce que** la couche de matériau semi-conducteur (14) est une couche de GaN ou d'un matériau III/N binaire, ternaire ou quaternaire.

13. Structure multicouche comprenant une structure composite (13) comprenant au moins une couche de germe cristallin de croissance (11) de matériau semi-conducteur sur un substrat support (10), la couche de germe cristallin de croissance (11) ayant un diamètre identique au diamètre du substrat support (10) et une épaisseur d'au moins 5 µm.

14. Structure multicouche selon la revendication 13, **caractérisée en ce qu'**elle comprend en outre une couche de matériau semi-conducteur (14) formée par croissance épitaxiale sur la couche de germe cristallin de croissance (11).

15. Structure selon la revendication 14, **caractérisée en ce que** la couche de matériau semi-conducteur (14) présente une épaisseur d'au moins 100 µm ou **en ce que** la couche de matériau semi-conducteur (14) et la couche de germe cristallin de croissance (11) présentent ensemble une épaisseur d'au moins 100 µm.
